# EUROPEAN PATENT APPLICATION

(11) **EP 1 460 154 A1**
(43) Date of publication of application: **22.09.2004**
(21) Application number: 02793431.4
(22) Date of filing: 26.12.2002
(51) Int. Cl.: C30B 29/38, H01L 21/205, H01L 33/00, H01S 5/323

(54) **GROUP III NITRIDE SEMICONDUCTOR SUBSTRATE AND ITS MANUFACTURING METHOD**

(30) Priority: 26.12.2001 JP 2001393056
(71) Applicant: Japan Science and Technology Agency, Kawaguchi-shi, Saitama 332-0012 (JP); National Institute for Materials Science, Tsukuba-shi, Ibaraki 305-0047 (JP)
(72) Inventor: Kamiyama, Satoshi, Nagoya-shi, Aichi 468-0004 (JP); Amano, Hiroshi, 508, Takara-Mansion Yamanote, Nagoya-shi, Aichi 465-0011 (JP); Akasaki, Isamu, Nagoya-shi, Aichi 451-0061 (JP); OHTANI, Shigeki, Tsukuba-shi, Ibaraki 305-0031 (JP); SUDA, Jun, Otsu-shi, Shiga 520-0852 (JP)
(74) Representative: Wagner & Geyer
(86) International application number: PCT/JP2002/013735
(87) International publication number: WO 2003/056073

(57) **Abstract**

Disclosed are a group III-nitride semiconductor substrate and a production method therefor. A group III-nitride semiconductor substrate having an element-forming surface with a dislocation density of 10⁷ cm⁻² or less in its entirely is formed only two steps. In a first step, a AlGaN-based low-temperature buffer layer is formed on a ZrB₂ single crystal base having a defect density of 10⁷ cm⁻² or less, at a base temperature allowing the low-temperature buffer layer to be grown or deposited on the ZrB₂ single crystal base substantially without creation of any Zr - B - N amorphous nitrided layer. Subsequently, in a second step, an AlGaN-based single crystal film is grown directly on the low-temperature buffer layer. The present invention can fully bring out the properties of the ZrB₂ single crystal base having a high potential as a base material capable of lattice marching with group III-nitride semiconductors, so as to achieve a high-quality AlGaN semiconductor layer with an element-forming surface having a low dislocation density, through a fully simplified process.

## Description

### TECHNICAL FIELD

The present invention relates to a group III-nitride semiconductor substrate which is expected to be applied to the fields of optical information processing and others, a method of producing the substrate, and a semiconductor optical element formed on the substrate.

### BACKGROUND ART

Heretofore, a group III-nitride semiconductor has been prepared through a so-called heteroepitaxial crystal growth process using a base material having a large lattice mismatch therewith, due to absence of any high-quality base material capable of lattice matching with the group III-nitride semiconductor. The most typical base material is sapphire.

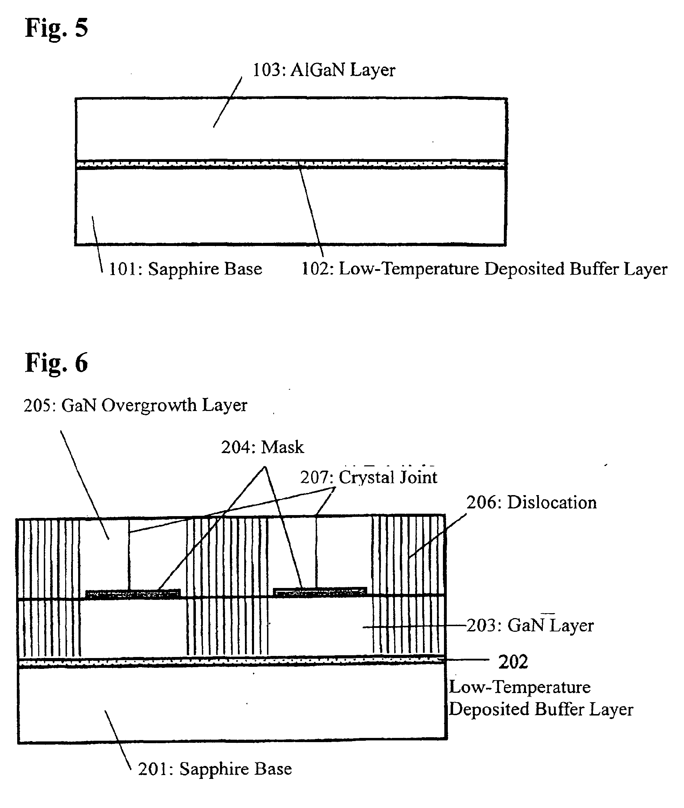

The conventional nitride semiconductor typically has a structure as shown in FIG. 5. Specifically, a GaN (or AlGaN) layer 103 is grown on a sapphire base 101 through a low-temperature deposited buffer layer 102 made of GaN or AlN. Generally, this low-temperature deposited buffer layer (hereinafter referred to as "low-temperature buffer layer") 102 is deposited at a film-forming temperature of 200 to 900°C, and formed to have an amorphous structure, a polycrystalline structure, or a mixed structure thereof. While the low-temperature buffer layer is also heated up to 900°C or more during a process of growing a nitride-based compound semiconductor layer thereon, to cause partial vaporization and the initiation of recrystallization thereof so as to form high-density crystal nuclei therein, it is still polycrystalline even after the recrystallization.

Originally, there is a relatively large lattice mismatch of no fewer than about 16% between the sapphire base 101 and the GaN (or AlGaN) layer 103. Thus, if the GaN layer is grown directly on the sapphire base 101, only a crystal with very poor quality can be prepared. In contrast, the low-temperature deposited buffer layer 102 inserted therebetween as shown in FIG. 5 can absorb the large lattice mismatch to allow the GaN (or AlGaN) layer 103 to be prepared with high quality.

Most of light-emitting diodes or semiconductor lasers using a nitride semiconductor have been prepared based on such a high-quality GaN (or AIGaN) layer 103. However, even a nitride semiconductor crystal layer prepared in the aforementioned manner still involves a practical problem of a high threading-dislocation density of 10⁸ cm⁻² or more.

For example, in a light-emitting element, it is known that the threading dislocations act as non-radiative recombination centers to cause deterioration in emission efficiency of the light-emitting element. It is also known that the threading dislocations have a serious adverse affect on the durability of the element because the degradation of the element is accelerated by the threading dislocations. In a light-receiving element, the threading dislocations cause increase in leak current or dark current during reverse bias to constitute a limiting factor of highly-sensitive light detection.

As one measure against such problems, the following Patent Publication 1 discloses a method comprising the steps of heating a low-temperature buffer layer to provide a single-crystallized first low-temperature buffer layer, growing a first single-crystal GaN film on the first low-temperature buffer layer (in this state, the first single-crystal GaN film includes a crystal defect of 10⁷ to 10¹¹ cm⁻²), forming a second low-temperature buffer layer on the first single-crystal GaN film, heating the second low-temperature buffer layer to provide a single-crystallized second low-temperature buffer layer, growing a second single-crystal GaN film on the second low-temperature buffer layer, and repeatedly forming the deposited/single-crystallized thin film and the grown single-crystal film alternately to form a semiconductor substrate having an average crystal-defect density of 1 × 10⁷ cm⁻² or less.

In late years, an epitaxial lateral overgrowth (ELO) technology has come into use as a measure for obtaining a reduced threading-dislocation density. FIG. 6 shows the structure of a low threading-density GaN substrate obtained using the ELO technology. In FIG. 6, a GaN layer 203 is grown on a sapphire base 201 through a low-temperature buffer layer 202 made of GaN or AlN. A plurality of masks 204, for example, made of SiO₂, are intervallicly formed on a surface of the GaN layer 203, and a GaN overgrowth layer 205 is further grown on the masks 204. The GaN overgrowth layer 205 starts growing only in regions devoid of the masks 204 or regions consisting of the exposed surfaces of the GaN layer 203. After a while, crystals laterally grown above the masks will entirely cover over the masks. Finally, a film having a flat surface is formed as shown in FIG. 6.

During the course of the above growth of the GaN overgrowth layer 205, almost no dislocation 206 threading the overgrowth layer 205 directly upward relative to its growth direction is originally formed above the stripe masks, except for crystal joints 207. Thus, each of the regions of the GaN overgrowth layer 205 formed above the stripe masks has an extremely low dislocation density of about 10⁵ to 10⁷ cm⁻², except for the central portion of each of the regions. A light-emitting diode or semiconductor laser prepared using this substrate can obtain excellent characteristics exhibiting reduced non-radiative recombination and high emission efficiency.

Furthermore, a photodetector formed in a low-dislocation-density region can have a dark current reduced in the level of several digits. The ELO technology is also used to prepare a GaN substrate. To prepare through theoretically the same method as that for the ELO layer in FIG. 6, a GaN overgrowth layer 205 is grown to have a thickness of several hundred µm using a halide vapor-phase epitaxy technology providing a high growth rate, and then the sapphire base 201 is removed through an etch or laser lift-off process from the GaN overgrowth layer which is used as the GaN substrate.

This ELO technology is disclosed, for example, in the following Patent Publications 2 to 5. For instance, Patent Publication 5, discloses a method comprising the steps of forming a first AlGaN layer on a sapphire base through a low-temperature buffer layer, and growing a second AlGaN layer having an Al composition less than that of the first AlGaN layer, on the first AIGaN layer to have a film thickness of 5 µm or more, while forming a facet structure from each of openings of a mask, to form a nitride semiconductor substrate with an element-forming surface (or a surface for use in forming an element thereon) having an average crystal-defect density of 1 × 10⁷ cm⁻² or less.

Currently, a low dislocation density of the level of 10⁵ cm⁻² is achieved, but partly, in a GaN substrate. An epitaxial growth process using this GaN substrate makes it possible to grow a lattice-matched crystal so as to achieve high-quality crystals and high-performance semiconductor elements.

However, in view of the following situations, it is believed that even nitride semiconductor crystals and semiconductor elements using the conventional low-dislocation-density GaN substrate should be further improved. Firstly, even though the currently achieved dislocation density is described as a low dislocation density, the level of 10⁵ cm⁻² is still not a sufficiently low value, and the GaN substrate partly has a region having a high dislocation density of 10⁸ cm⁻². Secondary, this substrate has to be prepared through an extremely complicated process which leads to a high cost.

In order to overcome this problem, great interest is shown in ZrB₂ (zirconium diboride) which is a heterogeneous base material (the following Non-Patent Publication 1). ZrB₂ is a material having a hexagonal unit cell identical to that of a nitride semiconductor, and capable of lattice matching with Al_{0.26}Ga_{0.74}N at room temperature. The following Patent Publication 6 discloses a method for growing a high-quality/large-size ZrB₂ single crystal using a floating zone process. A ZrB₂ single crystal produced using such a floating zone process may be used in the present invention.
Patent Publication 1: Japanese Patent Laid-Open Publication No. 11-162847
Patent Publication 2: Japanese Patent Laid-Open Publication No. 11-103135
Patent Publication 3: Japanese Patent Laid-Open Publication No. 11-251253
Patent Publication 4: Japanese Patent Laid-Open Publication No. 2001-60719
Patent Publication 5: Japanese Patent Laid-Open Publication No. 2001-308464
Patent Publication 6: Japanese Patent Laid-Open Publication No. 10-95699
Non-patent Publication 1: (H. Kinoshita, S. Ohtani, S. Kamiyama, H. Amano, I. Akasaki, J. Suda and H. Matsunami, "Japanese Journal of Applied Physics")

As described above, the threading dislocation as the conventional problem is caused by lattice mismatch. Thus, the above ZrB₂ single crystal base has the potential of achieving a dislocation-free high-quality nitride semiconductor. In addition, the ZrB₂ single crystal base fulfills all requirements for an epitaxial growth of nitride semiconductors, such as thermal expansion coefficient close to nitride semiconductors, high electrical conductivity and extremely high thermal stability. The establishment of large ZrB₂-single-crystal bulk growth technologies is lately accelerated, and it can be expected that a large-diameter base material will become available at a low cost in the near future.

On the other hand, it has been founded that a nitride semiconductor epitaxial growth using a ZrB₂ single crystal base practically involves difficulties in epitaxially growing a nitride semiconductor crystal. In view of these practical problems arising during the course of epitaxially growing a nitride semiconductor on a ZrB₂ single crystal base, it is therefore an object of the present invention to fully bring out the properties or features of the ZrB₂ single crystal base so as to achieve a high-quality nitride single-crystal semiconductor layer with an element-forming surface having a low dislocation density, through a fully simplified process.

### DISCLOSURE OF INVENTION

Through various researches on the causes of the above problems involved in the use of a ZrB₂ single crystal base, the inventors found that in a process of forming an AIGaN-based nitride semiconductor film, even if a surface of a ZrB₂ single crystal base is originally clean, a Zr-B-N amorphous nitrided layer is formed before initiation of the formation of an AlGaN-based low-temperature buffer layer as the result of diffusion/chemical bonding of a nitrogen atom arising from the decomposition of film-forming gas etc. to the surface of the ZrB₂ single crystal base, and the amorphous nitrided layer substantially precludes the growth of AIGaN-based nitride semiconductor or leads to the formation of island-shaped AlGaN-based nitride semiconductors, to cause the deterioration in surface smoothness of a grown layer and a number of defects in fused regions between the islands, resulting in the difficulty ofAlGaN-based single crystal growth.

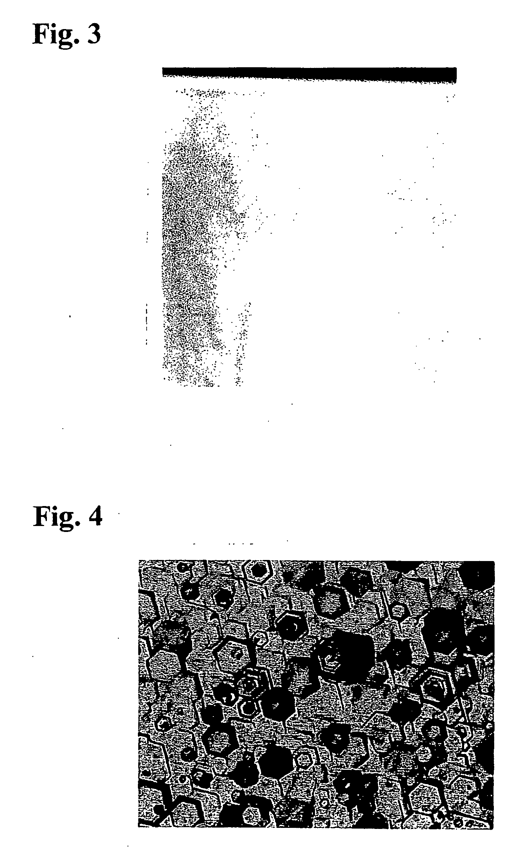

FIG. 4 is a transmission electron micrograph showing the section of an AlGaN-based semiconductor layer formed with such a Zr-B-N amorphous nitrided layer. As seen in the micrograph, a six-sided-pyramid-shaped microcrystal domain is formed, and the dislocation density of the entire element-forming surface is unmeasurably increased to preclude the AlGaN-based semiconductor layer from applying to any device production.

The inventors also found that the Zr-B-N amorphous nitrided layer is not unconditionally formed in the entire temperature range, and if the ZrB₂ single crystal base is controlled to be equal to or less than a certain temperature of the base (hereinafter referred to as "base temperature") meeting a requirement of allowing the growth or deposition of an AlGaN-based low-temperature buffer layer, raw materials of the low-temperature buffer layer can be supplied onto the surface of the base before and during the formation of the low-temperature buffer layer, without nitriding of the surface of the base, and successively an AlGaN-based single crystal film can be epitaxially grown to produce a low-dislocation-density high-quality AIGaN-based semiconductor substrate.

Specifically, the present invention provides a group III-nitride semiconductor substrate comprising a ZrB₂ single crystal base having a defect density of 10⁷ cm⁻² or less, a low-temperature buffer layer consisting of a BₓAl_{y}Ga_{z}In_{1-x-y-z}N (0 ≤ x ≤ 1, 0 ≤ y ≤ 1, 0 ≤ z ≤ 1, 0 ≤ 1- x- y- z ≤ 1) single crystal which is grown or deposited on the ZrB₂ single crystal base substantially without creation of any Zr - B - N amorphous nitrided layer caused by the reaction between a nitrogen atom and the ZrB₂ single crystal base, and a semiconductor layer which consists of a BₐAl_{b}Ga_{c}In_{1-a-b-c}N (0 ≤ a ≤ 1, 0 ≤ b ≤ 1, 0 ≤ c ≤ 1, 0 ≤ 1- a - b - c ≤ 1) single crystal grown on the low-temperature buffer layer, and has an element-forming surface with a dislocation density of 10⁷ cm⁻² or less in its entirely.

As used in the specification, the term "substantially without creation" means that, while some Zr-B-N amorphous nitrided layer is inevitably formed because it is practically difficult to perfectly prevent the formation of any interfacial amorphous layer in all epitaxial growth processes, a Zr-B-N amorphous nitrided layer which has an extremely small thickness of several atomic layers and allows potential energy of atomic arrangement under the amorphous nitrided layer to be transmitted to the upper surface thereof without interfering with adequate epitaxial growth is considered as nonexistent, and encompassed within the scope of the present invention. Further, in general, a process of depositing in the form of a single crystal is particularly referred to as "growth", and a process of depositing in the form of a polycrystalline or amorphous layer is referred to as "deposition". This specification also uses these terms in such meanings.

The present invention also provides a semiconductor optical element formed on the above semiconductor substrate.

The above semiconductor optical element may include an electrode formed on the side of the ZrB₂ single crystal base. In this case, the ZrB₂ single crystal base excellent in electrical conductivity allows the electrode to be formed on the side thereof so as to facilitate the production of an optical element or the like.

Further, the present invention provides a method of producing a group III-nitride semiconductor substrate, essentially consisting of a first step of forming a low-temperature buffer layer consisting of BₓAl_{y}Ga_{z}In_{1-x-y-z}N(0 ≤ x ≤ 1, 0 ≤ y ≤ 1, 0 ≤ z ≤ 1, 0 ≤ 1- x - y - z ≤ 1), on a ZrB₂ single crystal base having a defect density of 10⁷ cm⁻² or less, at a base temperature allowing the low-temperature buffer layer to be grown or deposited on the ZrB₂ single crystal base substantially without creation of any Zr - B - N amorphous nitrided layer, and a second step of successively to the first step, growing a single crystal film consisting of BₐAl_{b}Ga_{c}In_{1-a-b-c}N (0 ≤ a ≤ 1, 0 ≤ b ≤ 1, 0 ≤ c ≤ 1, 0 ≤ 1- a- b- c ≤ 1), directly on the low-temperature buffer layer, to form a semiconductor layer consisting of AlₐGa _{1-a-b}In_{b}N (0 ≤ a ≤ 1, 0 ≤ b ≤ 1, 0 ≤ 1- a- b ≤ 1) which has an element-forming surface with a dislocation density of 10⁷ cm⁻² or less in its entirely.

In the above method, the low-temperature buffer layer may be formed as a single crystal at the time the first step is completed.

Alternatively, the low-temperature buffer layer may be polycrystalline or amorphous at the time the first step is completed, and formed as a single-crystal at the time the second step is completed.

In the above method, the low-temperature buffer layer may have a thickness in the range of 10 nm to 1 µm.

Generally, a single crystal grown on a base material never has a dislocation density equal to or less than the defect density of the base material according to the principle of epitaxial growth. On the other hand, the upper limit of the dislocation density of the single crystal is varied depending on growth conditions. The method of the present invention can provide an AlGaN-based crystal with a dislocation density equal to several ten times less than the defect density of the ZrB₂ single crystal base. While any current ZrB₂ single crystal base has a crystal defect, and a nitride epitaxially grown on the base cannot have a dislocation density less than the defect density of the base even if the epitaxially growth is ideally performed, a nitride crystal having no dislocation can be theoretically obtained if the defect of the ZrB₂ single crystal base is further reduced to provide higher quality.

### BRIEF DESCRIPTION OF DRAWINGS

FIG. 1 is a conceptual diagram showing the structure of a low-dislocation-density group-III-nitride semiconductor substrate of the present invention.
FIG. 2 is a time chart of a base temperature and a gas supply in a production method for a low-dislocation-density group-III-nitride semiconductor substrate of the present invention
FIG. 3 is a transmission electron micrograph showing the section of a low-dislocation-density group-III-nitride semiconductor substrate produced in Example 1.
FIG. 4 is a transmission electron micrograph showing the section of a group-III-nitride semiconductor substrate having a Zr-B-N amorphous nitrided layer formed on a ZrB₂ single-crystal base.
FIG. 5 is a conceptual diagram showing the structure of a conventional group-III-nitride semiconductor substrate.
FIG. 6 is a conceptual diagram showing a low-dislocation-density GaN substrate formed using a conventional epitaxial lateral overgrowth (ELO) technology.

### BEST MODE FOR CARRYING OUT THE INVENTION

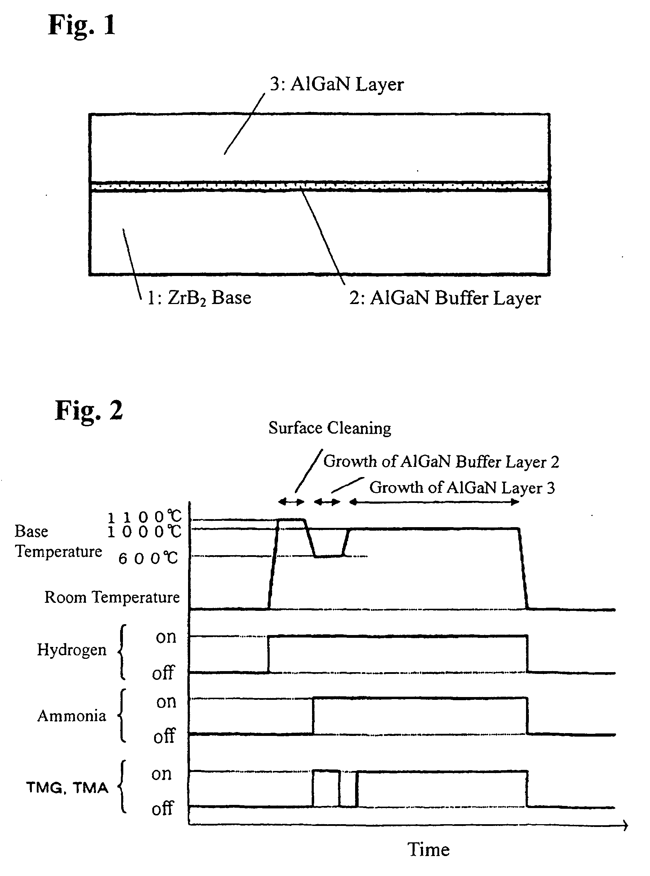

With reference to the drawings, an embodiment of the present invention will now be described in detail. FIG. 1 is a conceptual diagram showing the structure of a nitride semiconductor layer according to one embodiment of the present invention. FIG. 2 is a time chart of a base temperature and a gas supply in a production method for the nitride semiconductor layer.

A ZrB₂ single crystal base may be prepared by cutting a bulk crystal formed using a floating zone process and polishing the wafer to provide a mirror finished surface thereon. The ZrB₂ single crystal base has an atomic arrangement of the AlB₂ type hexagonal structure, and its lattice constant is about 3.17Å in actual measurement which is capable of lattice matching with a nitride crystal. The ZrB₂ single crystal base also has a thermal expansion coefficient of 5.9 × 10⁻⁶/K which approximately matches with a nitride crystal.

The ZrB₂ single crystal base mixedly has not only dislocations but also defects due to mixing of microparticle crystals having a different composition therefrom. Most of these dislocations and defects are distributed in the surface of the wafer at a defect density of about 10⁶ to 10⁷ cm⁻². In case where the ZrB₂ single crystal base has a defect density of greater than 10⁷ cm⁻², even if a low-temperature buffer layer consisting of BₓAl_{y}Ga_{z}In_{1-x-y-z}N (0 ≤ x ≤ 1, 0 ≤ y ≤ 1, 0 ≤ z ≤ 1, 0 ≤ 1- x - y - z ≤ 1) (hereinafter referred to as "BAlGaIn low-temperature buffer" in some cases) is grown at a temperature of the base, or a base temperature, allowing the low-temperature buffer layer to be grown on the base, a semiconductor layer consisting of AlₐGa _{1-a-b}In_{b}N (0 ≤ a ≤ 1, 0 ≤ b ≤ 1, 0 ≤ 1- a- b ≤ 1) (hereinafter referred to as "BAlGaInN semiconductor layer" in some cases) hardly has an element-forming surface with an average crystal defect density of 10⁷ cm⁻² or less in its entirety.

The term "average crystal defect density" means an average value of a crystal defect density measured over the entire element-forming surface. The term "defect" includes all of various modes of dislocation, and any other defects. The crystal defect density is measured by etching the surface of the semiconductor layer using a chemical solution, and counting the number of depressions (etch pits) formed by the etch, using an optical microscope or a scanning electron microscope to determine the density thereof.

Using the above ZrB₂ single crystal base, a BAlGaIn low-temperature buffer layer is formed on the ZrB₂ single crystal base at a base temperature allowing the low-temperature buffer layer to be grown or deposited on the base, substantially without creation of any Zr-B-N amorphous nitrided layer as the result of the diffusion and/or chemical bonding of a nitrogen atom arising from the decomposition of film-forming gas etc. to the surface of the ZrB₂ single crystal base, and successively a BAlGaIn single-crystal film is grown.

While a combination of 0% of the molar fraction of B and about 26% of the molar fraction of AlN in the composition of the BAlGaIn low-temperature buffer layer and the BAlGaIn single-crystal film provides a lattice match most close to the perfect lattice match to the base, the entire range of the composition is effective to reduction of the dislocation density over the entire element-forming surface. When the BAlGaIn low-temperature buffer layer and the BAlGaIn single-crystal film contain a large amount of In, they advantageously have an electrically low resistance.

If the base temperature at meets the above requirement when BAlGaIn low-temperature buffer layer is initially grown or deposited on the ZrB₂ single crystal base, the same effect can be obtained even by forming the film using any crystal growth process, such as organometallic vapor-phase epitaxy, molecular beam epitaxy and halide vapor-phase epitaxy. For example, in case of the organometallic vapor-phase epitaxy, the base temperature is preferably set at 750°C. The base temperature set at 800°C causes the deterioration in the crystal of the BAlGaIn single-crystal film, and the base temperature set at 900°C or more precludes the deposition of any crystal. In case of the molecular beam epitaxy, while the base temperature set at 800°C or more causes the deterioration in smoothness of the film, the level of the deterioration is slightly better than that in the organometallic vapor-phase epitaxy.

As long as the BAlGaIn low-temperature buffer layer is formed through each of the growth process, the lower limit of the base temperature is not limited to a specific value. For example, the lower limit of the base temperature may be about 400°C for the organometallic vapor-phase epitaxy involving the thermal decomposition of raw materials, or may be 200°C for a process, such as the molecular beam epitaxy, in which simple elements are directly supplied.

If the base temperature goes beyond the above base temperature condition during the film formation of the BAlGaIn low-temperature buffer layer, the reaction between a nitrogen atom arising from the decomposition of ammonia and the surface of the ZrB₂ single crystal base causes the nitriding in the surface of the ZrB₂ single crystal base to form a Zr-B-N amorphous nitrided layer. This amorphous nitrided layer has an atomic arrangement different from that of the ZrB₂ single crystal base, and an extremely small number of bonding links for establishing the bond with constitutive elements, such as Ga and Al, which are successively supplied during the growth of the BAlGaIn single-crystal film. Thus, any crystal growth becomes approximately impossible.

It is believed that the Zr-B-N amorphous nitrided layer is formed at the above specific base temperature by the following reason. In order to form the chemical bonding between the nitrogen atom and Zr or B in the surface of the ZrB₂ single crystal base, the nitrogen atom is required to get close to the Zr or B atom against a surface potential (potential energy acting to prevent the nitrogen atom from getting close to the surface). Thus, the surface of the ZrB₂ single crystal base is nitrided only if an energy greater than the surface potential is given to the nitrogen atom. Such energy is given to the nitrogen atom through the radiation of heat from the surface of the ZrB₂ single crystal base, and thereby the nitriding of the ZrB₂ single crystal base is initiated when the base temperature is increased up to a certain temperature.

The low-temperature buffer layer on the conventional sapphire base serves as a layer for forming crystal nuclei and acts to absorb lattice mismatch. In contrast, the present invention utilizes a function of the BAlGaIn low-temperature buffer layer, capable of suppressing the nitriding of the surface of the ZrB₂ single crystal base. Thus, in terms of mechanism, the present invention is totally different from the conventional growth method. Due to this difference, the present invention and the conventional growth method are also different in the growth temperature range for the respective low-temperature buffer layers.

Furthermore, as the structural difference therebetween, while the low-temperature buffer layer on the conventional sapphire substrate is required to accurately set its film thickness in the range of 10 nm to 50 nm, the BAlGaIn low-temperature buffer layer in the present invention may have a thickness of at least 10 nm to prevent the Zr-B-N amorphous nitrided layer from being formed on the ZrB₂ single crystal base. Only if the BAlGaIn low-temperature buffer layer has a thickness of greater than 1 µm, a time-period required for single-crystallizing the BAlGaIn low-temperature buffer layer during heating will be extended to preclude the availability as a practical crystal growth process. Thus, the thickness of the BAlGaIn low-temperature buffer layer has high flexibility or availability in the wide range of 10 nm to 1 µm. In a practical sense, it is more preferably in the range of about 20 to 200 nm.

After the formation of the BAlGaIn low-temperature buffer layer, the BAlGaIn single-crystal film is successively grown on the BAlGaIn low-temperature buffer layer. When the BAlGaIn low-temperature buffer layer is grown at a temperature of less than 600°C, the growth temperature of the BAlGaIn single-crystal film is preferably set at 600°C or more, more preferably 800°C or more, so as to facilitate the migration of the constitutive elements in the surface the ZrB₂ single crystal base to produce adequate single crystal. Even if the BAlGaIn single-crystal film is grown at a temperature of less than 600°C, the BAlGaIn low-temperature buffer layer will be single-crystallized during the heating of the BAlGaIn single-crystal film to the growth temperature, so as to improve the quality of the BAlGaIn low-temperature buffer layer to avoid any problem of quality.

### [EXAMPLE]

### (Example 1)

A (0001) ZrB₂ single crystal base 1 as a substrate for forming a nitride semiconductor was first introduced in an organometallic vapor-phase epitaxial growth apparatus. The ZrB₂ single crystal base was prepared by cutting a bulk crystal produced through a floating zone process in Japan National Institute for Materials Science, to obtain a wafer having a thickness of about 0.3 mm, and polishing the wafer to provide a mirror finished surface thereon.

Then, the temperature of the base was increased up to 1100°C. Then, the base temperature was maintained for 10 minutes. During this process, a gas containing hydrogen was introduced to remove an oxidized layer on the surface of the ZrB₂ single crystal base. Successively, the base temperature was reduced to 600°C, and then trimethyl aluminum (TMA), trimethyl gallium (TMG) and ammonia were introduced in a reaction tube to grow an AlGaIn low-temperature buffer layer 2 having a film thickness of 50 nm on the ZrB₂ single crystal base 1 within a growth time of about 2 minutes, under the condition that the flow volumes of TMA, TMG and ammonia were set at 5 sccm, 5 sccm and 1 slm, respectively.

Then, the base temperature was increased up to about 1000°C, an AlGaIn single-crystal film 3 having a thickness of 2 µm was grown on the low-temperature buffer layer 2 within a growth time of about 30 minutes, under the condition that the flow volumes of TMA, TMG and ammonia were set at 10 sccm, 10 sccm and 1 slm, respectively.

FIG. 3 is a transmission electron micrograph showing the section of the AlGaIn single-crystal film 3 on the ZrB₂ single crystal base 1, prepared in this way. In FIG. 3, the number of dislocations threading to the surface of the AlGaIn single-crystal film 3 was about one, and the threading dislocation density was about 10⁷ cm⁻² equivalent to the defect density of the ZrB₂ single crystal base 1. Almost no occurrence of dislocation was observed in the interface between the ZrB₂ single crystal base 1 and the AlGaIn low-temperature buffer layer 2/AlGaIn single-crystal film 3.

### INDUSTRIAL APPLICABILITY

The present invention can provide a reduced dislocation density a group III-nitride semiconductor substrate over the entire element-forming surface thereof, which could not be achieve in conventional substrates such as a single-crystal GaN substrate, through a fully simplified process. Therefore, the semiconductor substrate of the present invention is significantly useful to light-emitting diodes, and light-receiving elements, such as a photodiode, which essentially require a lower dislocation density in a wider area.

## Claims

1. A group III-nitride semiconductor substrate comprising:
a ZrB₂ single crystal base having a defect density of 10⁷ cm⁻² or less;
a low-temperature buffer layer consisting of a BₓAl_{y}Ga_{z}In_{1-x-y-z}N (0 ≤ x ≤ 1, 0 ≤ y ≤ 1, 0 ≤ z ≤ 1, 0 ≤ 1- x - y - z ≤ 1) single crystal which is grown or deposited on said ZrB₂ single crystal base substantially without creation of any Zr - B - N amorphous nitrided layer caused by the reaction between a nitrogen atom and said ZrB₂ single crystal base; and
a semiconductor layer consisting of a BₐAl_{b}Ga_{c}In_{1-a-b-c}N (0 ≤ a ≤ 1, 0 ≤ b ≤ 1, 0 ≤ c ≤ 1, 0 ≤ 1- a- b- c ≤ 1) single crystal grown on said low-temperature buffer layer, said semiconductor layer having an element-forming surface with a dislocation density of 10⁷ cm⁻² or less in its entirely.

2. A semiconductor optical element formed on the semiconductor substrate as defined in claim 1.

3. The semiconductor optical element as defined in claim 2, which includes an electrode formed on the side of said base.

4. A method of producing a group III-nitride semiconductor substrate, essentially consisting of:
a first step of forming a low-temperature buffer layer consisting of BₓAl_{y}Ga_{z}In_{1-x-y-z}N (0 ≤ x ≤ 1, 0 ≤ y ≤ 1, 0 ≤ z ≤ 1, 0 ≤ 1- x - y - z ≤ 1), on a ZrB₂ single crystal base having a defect density of 10⁷ cm⁻² or less, at a base temperature allowing said low-temperature buffer layer to be grown or deposited on said ZrB₂ single crystal base substantially without creation of any Zr - B - N amorphous nitrided layer; and
a second step of successively to said first step, growing a single crystal film consisting of BₐAl_{b}Ga_{c}In_{1-a-b-c}N (0 ≤ a ≤ 1, 0 ≤ b ≤ 1, 0 ≤ c ≤ 1, 0 ≤ 1- a - b - c ≤ 1), directly on said low-temperature buffer layer, to form a semiconductor layer consisting of AlₐGa _{1-a-b}In_{b}N (0 ≤ a ≤ 1, 0 ≤ b ≤ 1, 0 ≤ 1- a- b ≤ 1) which has an element-forming surface with a dislocation density of 10⁷ cm⁻² or less in its entirely.

5. The method as defined in claim 4, wherein said low-temperature buffer layer is formed as a single crystal at the time said first step is completed.

6. The method as defined in claim 4, wherein said low-temperature buffer layer is polycrystalline or amorphous at the time said first step is completed, and formed as a single-crystal at the time said second step is completed.

7. The method as defined in either one of claims 4 to 6, wherein said low-temperature buffer layer has a thickness in the range of 10 nm to 1 µm.
